# EUROPEAN PATENT SPECIFICATION

(11) **EP 3 050 935 B1**
(45) Date of publication and mention of the grant of the patent: **05.03.2025**
(21) Application number: 16153183.5
(22) Date of filing: 28.01.2016
(51) Int. Cl.: C09K 11/02, C09K 11/08, C09K 11/56, C09K 11/62, C09K 11/64, B82Y 30/00

(54) **MANUFACTURING METHOD OF A QUANTUM DOT ENSEMBLE**
HERSTELLUNGSVERFAHREN FÜR QUANTENPUNKTENSEMBLE
PROCÉDÉ DE FABRICATION D'UN ENSEMBLE DE POINTS QUANTIQUES

(30) Priority: 29.01.2015 JP 2015014921; 21.12.2015 JP 2015248147
(43) Date of publication of application: 03.08.2016
(73) Proprietor: Stanley Electric Co., Ltd., Meguro-ku Tokyo 153-8636 (JP)
(72) Inventor: KAZAMA, Takuya, Tokyo, 153-8636 (JP); TAMURA, Wataru, Tokyo, 153-8636 (JP); MIYAKE, Yasuyuki, Tokyo, 153-8636 (JP)
(74) Representative: Wagner & Geyer

(56) References cited:
- EP-A1- 3 050 936
- US-A1- 2003 194 731
- US-A1- 2011 101 387
- US-A1- 2013 193 407
- STEPHEN J. BYRNE ET AL: "Preparation and biological investigation of luminescent water soluble CdTe nanoparticles", OPTICAL SENSING II, vol. 5824, 2 June 2005 (2005-06-02), 1000 20th St. Bellingham WA 98225-6705 USA, pages 129, XP055282403, ISSN: 0277-786X, ISBN: 978-1-62841-971-9, DOI: 10.1117/12.604814

## Description

### BACKGROUND OF THE INVENTION

### A) FIELD OF THE INVENTION

The present invention relates to a manufacturing method of a quantum dot ensemble. More specifically, the invention relates to a manufacturing method of a quantum dot ensemble having a uniform band gap, even when variations in a size and a composition are large. In a case of quantum dots which are formed of a group II-VI ZnOS semiconductor material consisting of ternary or more compositions, a specific effect is exhibited.

The quantum dots are formed by using a semiconductor material and are particles of which an average particle size is in the range of nanometers. Here, the average particle size represents a median diameter when a distribution of an equivalent circle diameter is formed based on the number of particles, in which the area equivalent circle diameter is calculated for each particle by observing the quantum dots with a transmission electron microscope.

### B) DESCRIPTION OF THE RELATED ART

As quantum dots consisting of a binary crystal of a group II-VI semiconductor material, quantum dots having a relatively uniform size and composition can be obtained through, for example, a liquid phase synthesis method represented by a hot injection method (for example, refer to website of Sigma-Aldrich Co. LLC. (http://www.sigmaaldrich.com/japan/materialscience/nano-materials/lumidots.htm I)). However, in a case of a ternary mixed crystal, it cannot be said that ease of control of the size and composition thereof is sufficient.

In the quantum dots, an energy gap is changed depending on the size thereof and a composition of a crystal. The change of the energy gap due to the size is limited to a case of a nanometer size, and the reason for this is that a quantum effect is expressed.

Particularly, in a ternary mixed crystal, an emission spectrum spreads due to variations in the size and composition, and thus, it is difficult to manufacture quantum dots having an emission spectrum of a narrow band. In addition, after manufacturing the quantum dots, separating and selecting the quantum dots having the variations in the size and composition lead to significant reduction in yield and significant increase in cost, which is not realistic.

ZnOₓS₁₋ₓ quantum dots are capable of being synthesized through a solution method such as a solvothermal method by using a hot soap method and an autoclave, or a vapor phase such as a sputtering method. However, in the quantum dots which are synthesized through the above methods, it is difficult to control the size and composition, and thus, quantum dots having different size and composition may be mixed into the synthesized quantum dot ensemble. For this reason, a half-width of an emission spectrum of the quantum dot ensemble broadly spreads in a range of 50 nm to 200 nm, and thus, it is difficult to realize a narrow emission spectrum.

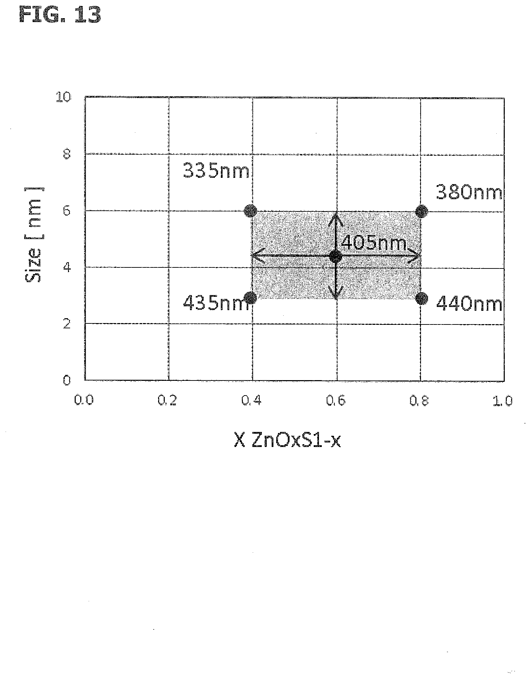

Fig. 13 is a graph illustrating a relationship between an O composition x and size of ZnOₓS₁₋ₓ, and a light emitting wavelength. ZnOₓS₁₋ₓ is synthesized by setting the O composition x to be 0.6, and the size to be 4.0 nm (light emitting wavelength is set to be 405 nm (3.06 eV)), and in the synthesized ZnOₓS₁₋ₓ, in a case where the variation in each of the O composition x and the size is generated in the respective ranges of 0.4 to 0.8 and 3.0 nm to 6.0 nm, the light emitting wavelength spreads in a range of 335 nm to 440 nm (3.70 eV to 2.84 eV). The light emitting wavelength is widened, and thus, it is very difficult to suppress the half width of the emission spectrum to be less than 50 nm.

Meanwhile, also in a core/shell type quantum dots, for example, when a shell layer is formed of a mixed crystal consisting of three or more elements, it is difficult to control a mixed crystal ratio. In the quantum dot ensemble, the band gap energy of the shell layer is varied for the quantum dots as a composition ratio of the shell layer is varied for each quantum dot. For this reason, even in a case where the band gap energy of a core layer (which includes a single composition, a binary composition, and a ternary or more mixed crystal composition) is constantly controlled, a confinement effect of the core layer is changed for each quantum dot. That is, the wavelength spectrum of the quantum dot ensemble broadly spreads, and thus, it is difficult to obtain a narrow emission spectrum.

US 2011-101387 A discloses a light emitting device including a light emitting element, and a semiconductor phosphor microparticle having a core/shell structure having a shell part absorbing at least a part of the light emitted by the light emitting element, and an image display device including a light emitting element, and a semiconductor phosphor microparticle having a core/shell structure having a shell part that absorbs at least a part of the light emitted by the light emitting element.

STEPHEN J. BYRNE ET AL, "Preparation and biological investigation of luminescent water soluble CdTe nanoparticles", OPTICAL SENSING II, 1000 20th St. Bellingham WA 98225-6705 USA, (20050602), vol. 5824 discloses CdTe quantum dots which are prepared in aqueous medium using several different thiol stabilizers.

US 2003/194731 A1 measures defect fluorescence exhibited from a defect level mainly on a semiconductor nanoparticle surface site which has an energy level existing inside the forbidden band of energy levels inside the semiconductor nanoparticle. Fluorescence is strongly exhibited in the case of ZnS when zinc perchlorate and hydrogen sulfide gas are mixed in a nitrogen atmosphere. Further, in the case of CdS, after cadmium perchlorate and hydrogen sulfide gas are mixed in a nitrogen atmosphere and the grain size is monodispersed by an optical etching method, the fluorescence is strongly exhibited. Furthermore, semiconductor nanoparticles prepared by methods other than the above exhibit defect fluorescence in most cases.

### SUMMARY OF THE INVENTION

Accordingly, it is an object of the present invention to provide a manufacturing method of a quantum dot ensemble in which a half-width of an emission spectrum is narrow, for example, the half width is less than 50 nm.

According to the present invention, there is provided a manufacturing method of a quantum dot ensemble as set forth in claim 1.

Preferred embodiments of the present invention may be gathered from the dependent claims.

In the above optical etching step, the plurality of quantum dots have a varied band gap because one of, or both of a mixed crystal composition and a size are varied. Then, the plurality of quantum dots having the varied band gap are put into an etchant, and are irradiated with the light corresponding to a target band gap. The quantum dots having a band gap which is narrower than the irradiation light are dissolved by an excited carrier, and thus, the band gap widens. On the other hand, quantum dots having a band gap which is wider than the irradiation light do not absorb the light, and thus are not dissolved. For this reason, it is possible to uniformize a band gap of a quantum dot ensemble which has variations in the composition and size, for example.

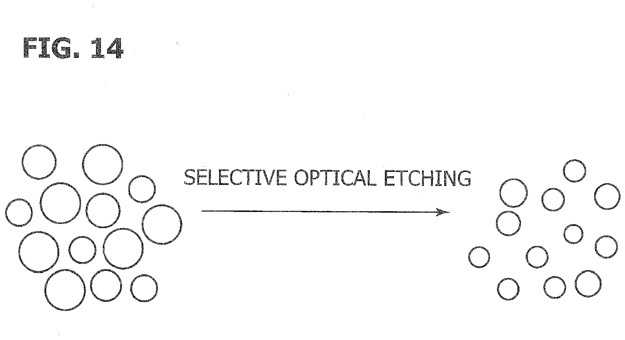

Fig. 14 schematically illustrates a change of the quantum dots through the optical etching.

The quantum dots having variations in the composition and (or) the size are uniformized to be a certain size through, for example, an etching process by light control. The etching is performed on the quantum dots having a size which is sufficient for absorbing the irradiation light. In addition, when the size of the quantum dot becomes small through the etching, and then the irradiation light transmits through the quantum dot, the etching is stopped. In the optical etching, it is possible to control the quantum dots to have, for example, a desired uniformed size by selecting the wavelength of the light.

Meanwhile, for example, in a case of a single composition of a ternary mixed crystal, each of a size and an energy gap is constant. When the composition is varied, the size is varied, but the energy gap is constant.

According to the invention, it is possible to provide a manufacturing method of a quantum dot ensemble which has a small half width of the emission spectrum, for example, the half width which is less than 50 nm.

### BRIEF DESCRIPTION OF DRAWINGS

Fig. 1A is a graph illustrating a relationship between an O composition x and band gap energy in a mixed crystal of ZnOₓS₁₋ₓ, and Fig. 1B is a graph illustrating a relationship between crystal sizes of ZnO and ZnS and a light emitting wavelength (band gap energy).
Fig. 2 is a flow chart schematically illustrating a manufacturing method of a quantum dot ensemble according to a first embodiment.
Fig. 3A is a schematic diagram of a manufacturing apparatus which manufactures quantum dots (a base material) through a hot injection method, and Fig. 3B is a schematic diagram of an ensemble (ZnOₓS₁₋ₓ nanoparticle ensemble) of quantum dot base materials.
Fig. 4A is a schematic diagram of an optical etching apparatus, Fig. 4B is a schematic diagram illustrating a quantum dot ensemble (ZnOₓS₁₋ₓ nanoparticle ensemble) after being irradiated with the light, and Fig. 4C is a graph illustrating a relationship between the O composition x and the size of the quantum dot ensemble after being irradiated with the light, and the band gap energy (light emitting wavelength).
Fig. 5 is a diagram illustrating a band line-up of In_{y}Al_{1-y}N (0 < y < 1) and ZnOₓS₁₋ₓ (0 < x < 1).
Fig. 6A is a flow chart schematically illustrating a manufacturing method of a quantum dot ensemble according to a first comparative example, and Fig. 6B is sectional view schematically illustrating the quantum dot (a core/shell structure) ensemble manufactured through the manufacturing method according to the first comparative example.
Fig. 7 is a flow chart schematically illustrating a manufacturing method of a quantum dot ensemble according to a second comparative example.
Fig. 8 is a sectional view of a quantum dot manufactured through the manufacturing method according to the second comparative example and is a diagram illustrating a target value of a band structure.
Fig. 9 is a flow chart schematically illustrating a manufacturing method of a quantum dot ensemble according to a second embodiment.
Fig. 10 is a sectional view of the quantum dot which is manufactured through the manufacturing method according to the second embodiment, and is a diagram illustrating a target value of the band structure.
Fig. 11 is a flow chart schematically illustrating a manufacturing method of a quantum dot ensemble according to a third comparative example.
Fig. 12 is a sectional view of the quantum dot manufactured through the manufacturing method according to the third comparative example, and is a diagram illustrating a target value of a band structure.
Fig. 13 is a graph illustrating a relationship between an O composition x and a size of ZnOₓS₁₋ₓ, and a light emitting wavelength.
Fig. 14 is a diagram conceptionally illustrating a change of quantum dots by optical etching.

### DESCRIPTION OF EMBODIMENTS

The embodiments of the invention will be described by exemplifying light emitting nanoparticles (quantum dots) formed of a ternary ZnOₓS₁₋ₓ (0 < x < 1) which is a group II-VI compound semiconductor.

First, a ZnOₓS₁₋ₓ mixed crystal will be briefly described.

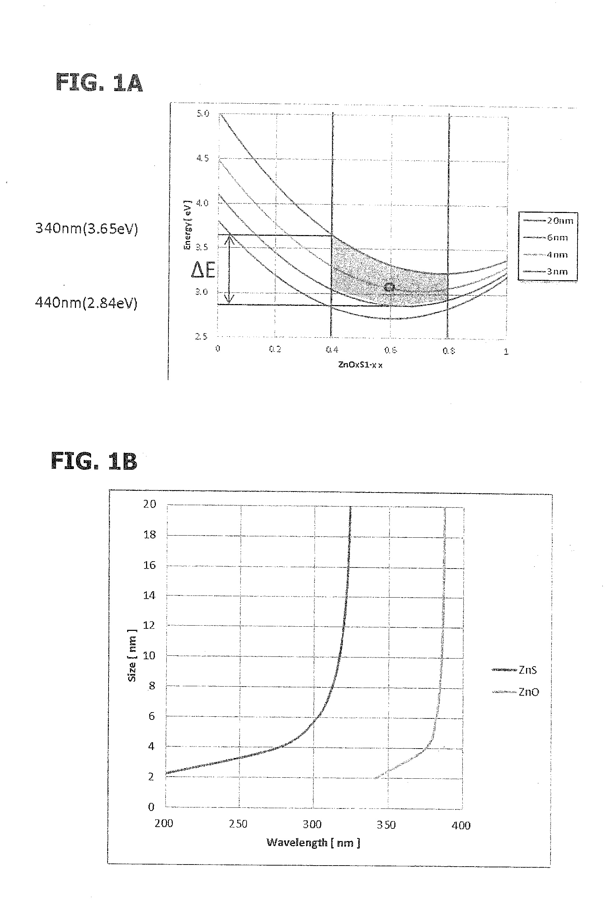

Fig. 1A is a graph illustrating a relationship between an O composition x and band gap energy in a mixed crystal of ZnOₓS₁₋ₓ. In Fig. 1A, the relationship between the O composition x and the band gap energy in a case where particle sizes are 3 nm, 4 nm, 6 nm, and 20 nm. The curved lines represent 3 nm, 4 nm, 6 nm, and 20 nm in order from the above. A circle represents a position in which x is 0.6, and the particle size is 4.0 nm. A variation in the O composition x is set to be in a range of 0.4 to 0.8, a variation in the size is set to be in a range of 3.0 nm to 6.0 nm, and then the ranges are darkly shaded. In addition, a ZnOₓS₁₋ₓ mixed crystal has a large variation in the composition.

For example, according to a technique in the related art, when a target value is set that the O composition x is 0.6 and the size is 4.0 nm in the ZnOₓS₁₋ₓ, it is possible to manufacture a nanoparticle ensemble in which the particle having the O composition x in a range of 0.4 to 0.8, and the size in a range of 3.0 nm to 6.0 nm is mixed (in the ZnOₓS₁₋ mixed crystal, since the variation in the composition and a bowing phenomenon are large, a synthesized nanoparticle becomes a nanoparticle having a value that the O composition x is in a range of 0.4 to 0.8 and the size is in a range of 3.0 nm to 6.0 nm on the basis of the target value that the O composition x is 0.6 and the size is 4.0 nm).

In a case where the variation in the O composition x is set to be in the range of 0.4 to 0.8 and the variation in the size is set to be in the range of 3.0 nm to 6.0 nm, the band gap energy becomes in a range of 2.84 eV to 3.65 eV (the light emitting wavelength becomes in a range of 440 nm to 340 nm).

In addition, the band gap energy of each of the ZnO and ZnS is 3.2 eV and 3.8 eV, and a bowing parameter b is 3.0. The ZnOₓS₁₋ₓ (x = 0.6) mixed crystal having 4.0 nm of particle size has a large bowing parameter, and thus, has smaller band gap energy than that of a binary crystal of ZnO and ZnS.

Fig. 1B is a graph illustrating a relationship between crystal sizes of ZnO and ZnS and a light emitting wavelength (band gap energy) in a state where a curved line on the right side is ZnO, and a curved line on the left side is ZnS. Regarding the ZnOₓS₁₋ₓ (0 < x < 1) mixed crystal, if the size is set to be equal to or less than 20 nm, or particularly, is set to be equal to or less than 10 nm in order to calculate a value between two curved lines illustrated in Fig. 1B, a carrier is confined due to a quantum effect, and thus, the light emitting wavelength is shifted to the short wavelength side (the side on the band gap energy is high).

In addition, each band gap energy (ZnO is 3.2 eV and ZnS is 3.8 eV) of the above-described ZnO and ZnS corresponds to the wavelength little less than 390 nm and the wavelength little less than 330 nm.

As illustrated in Fig. 1A and Fig. 1B, it is possible to change the band gap such that an energy level of as low as 2.7 eV which cannot be realized in the binary crystal of ZnO and ZnS (refer to the curved line at a size of 20 nm in Fig. 1A) is changed to an energy level of as high as 6.0 eV (refer to Fig. 1B. In ZnOₓS₁₋ₓ (0 < x < 1) close to ZnS (x is close to 0), the wavelength can be changed to be less than 205 nm (energy conversion: 6.0 eV) due to the quantum effect) by controlling the mixed crystal composition and the size of ZnOₓS₁₋ₓ (0 < x < 1).

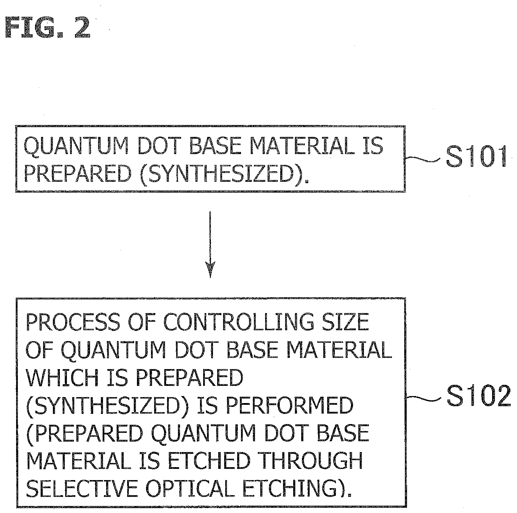

Fig. 2 is a flow chart schematically illustrating the manufacturing method of the quantum dot ensemble according to the first embodiment.

In the first embodiment, first, a quantum dot base material is prepared, and is synthesized as an example (Step S101). Next, a step of controlling the size of the quantum dot base material which is prepared (synthesized) in Step S101 is performed. Specifically, the prepared quantum dot base material is etched through the selective optical etching (Step S102).

In a particulating process in the selective optical etching step (Step S102), for example, the quantum dots (the base material) are dispersed in the solution, the dispersion liquid is irradiated with narrow band light. With this, only the particles having the large size are activated by absorbing the light, and then are etched. The quantum dots having the size which is sufficient for absorbing the light are etched, and thus the size thereof is reduced. When the size is reduced, the band gap becomes larger due to the quantum effect. When the band gap becomes larger than the energy of the irradiation light, the light transmits without absorbing the light. If the light transmits through the quantum dot, the etching is stopped. When the band gap for each the quantum dot is uniformized in the quantum dot ensemble through the selective optical etching step (Step S102), it is possible to selectively synthesize, for example, the quantum dots having the same band gap, that is, the same light emitting wavelength.

In the first embodiment, target values of the O composition x and the size of the quantum dot which is ultimately manufactured are respectively 0.60 and 4.0 nm.

In addition, a spherical quantum dot base material is formed in the embodiment. After the selective optical etching, the quantum dot is also formed into a spherical shape.

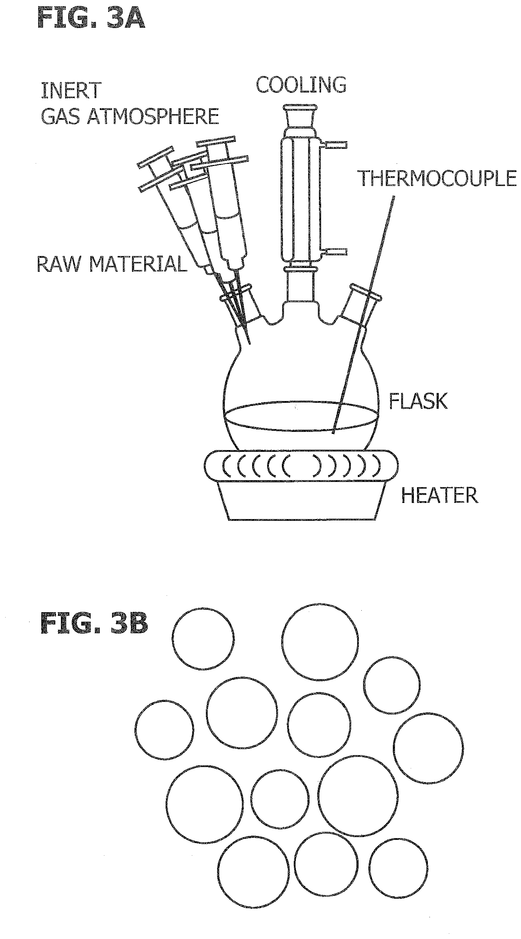

Fig. 3A is a schematic diagram of a manufacturing apparatus which manufactures quantum dots (a base material) through a hot injection method. A synthesizing step (Step S101) of the quantum dot base material will be described with reference to Fig. 3A.

A quartz flask (300 cc) is prepared as a reaction container. A port, through which an inert gas can be replaced with air in the flask, and a dedicated port, into which a reactive precursor can be injected, are attached to the flask in addition to an outlet. TOPO (tri-n-octyl phosphine oxide) and HDA (Hexadecylamine) which are reaction solvents are put into the flask, are heated at 300°C in an inert gas atmosphere, and then dissolved. For example, 8 g of TOPO, 4 g of HDA, and argon (Ar) as the inert gas are used. The above materials are stirred with a stirrer such that heating unevenness is hardly caused.

Next, syringes which are respectively filled with, as the reactive precursor, diethyl zinc (Zn(C₂H₅)₂) sealed by the inert gas (for example, Ar), octylamine (C₈H₁₇NH₂) which is bubbled with oxygen, and bis(trimethylsilyl) sulfide (thiobis) are respectively prepared. Oxygen is entrapped into octylamine (C₈H₁₇NH₂) by being bubbled with oxygen. For example, diethyl zinc (Zn(C₂H₅)₂), octylamine (C₈H₁₇NH₂) into which the oxygen is entrapped, and bis(trimethylsilyl) sulfide (thiobis) are respectively adjusted to be 4.0 mmol, 2.4 mmol, and 1.6 mmol. By adjusting as described above, a ZnO_{0.60}S_{0.40} mixed crystal nanoparticle (O composition x is 0.60 which is a target value) is synthesized in the first embodiment. In addition, when the O composition x is synthesized with the ZnOₓS₁₋ₓ mixed crystal nanoparticle which is different from the O composition x, the ratio of diethyl zinc (Zn(C₂H₅)₂), octylamine (C₈H₁₇NH₂), and bis(trimethylsilyl) sulfide (thiobis) may be changed.

When the reaction solvent has reached a reaction temperature, the reactive precursor is immediately put into the flask by using each syringe. A nucleus crystal of ZnOₓS₁₋ₓ is generated by thermal decomposition of the reactive precursor. If the reactive precursor is left to stand as it is, most of the reactive precursors are used to form the nucleus, and different sizes of nuclei are generated over time, and thus, the temperature of the flask is rapidly cooled to 200°C immediately after injecting the reactive precursor. Thereafter, a growth of ZnOₓS₁₋ₓ is performed in such a manner that the reaction solvent is heated again up to 240°C, and kept at a certain temperature for 40 minutes.

The flask is naturally cooled to 100°C, and then left to stand for one hour. With this, it is possible to stabilize the surface of the nanoparticle. This process is called a stabilizing process. Thereafter, butanol as an anti-caking agent is added to the reaction solution which is cooled to room temperature and the reaction solution is left to stand for 10 hours so as to prevent the nanoparticles from being aggregated. This process is called an aggregation prevention process. The mixture is purified by repeatedly performing centrifugation (4000 rpm for 10 minutes) by alternately using dehydrated methanol in which the solvent (TOPO) is dissolved, and toluene which disperses the nanoparticles. As a result, unnecessary raw materials and the solvent are removed. This process is called a purifying process.

As described above, in the step of synthesizing the quantum dot base material (Step S101), a number of ZnO_{0.60}S_{0.40} nanoparticles (O composition x is 0.60 which is the target value) are synthesized. Fig. 3B illustrates a schematic diagram of an ensemble (ZnOₓS₁₋ₓ nanoparticle ensemble) of the quantum dot base materials.

In the embodiment, all of the nanoparticles (base materials) are synthesized in a size larger than the size of the target particle. In the first embodiment in which the target values of the O composition x and the size of the quantum dots which are manufactured at final are respectively 0.60 and 4.0 nm, the nanoparticles (base material) are synthesized in a size which is larger than 10 nm, or the size which is larger than 20 nm.

However, since variations in the mixed crystal composition and the particle size occur in the quantum dot base material (nanoparticle) (for example, the variation occurs in the size in the range which is greater than the target size. At the time of the base material synthesis, in a case where the nanoparticle having the size which is larger than 4.0 nm is synthesized, variation occurs in the range in which the size is greater than 4.0 nm.), the light emitting wavelength is widened (the half width of the emission spectrum is, for example, equal to or greater than 50 nm).

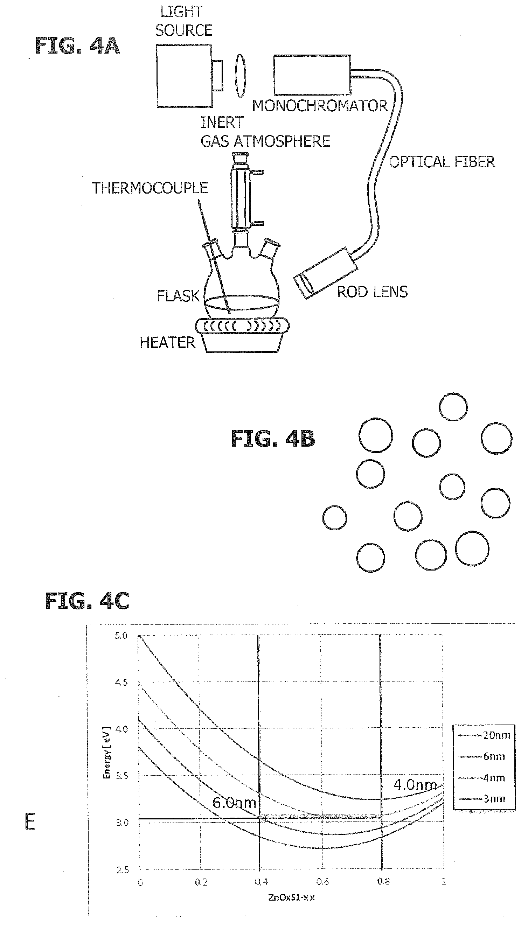

Fig. 4A is a schematic diagram of an optical etching apparatus. A selective optical etching step (Step S102) will be described with reference to Fig. 4A.

The quantum dot base material (the ZnO_{0.60}S_{0.40} nanoparticle) which is synthesized in Step S101 is in a state of being dispersed in the methanol after the stabilizing process, the aggregation prevention process, and the purifying process. Here, the methanol is vaporized so as to concentrate the nanoparticles. At this time, if the methanol is completely vaporized, the nanoparticles are aggregated, and therefore, it is preferable that the methanol slightly remains. Ultra pure water which is an optical etching liquid is added to the methanol and a solution of nanoparticle. The mixture is kept at 25°C, and is bubbled with oxygen for 5 minutes.

After being bubbled, the mixture is moved to the sealed container (the flask in Fig. 4A), and then the etching liquid is irradiated with the light having the light emitting wavelength of 405 nm (3.06 eV) and a half-width of 6 nm, which is the light having a wavelength which is sufficiently shorter than an absorption edge wavelength of the ZnO_{0.60}S_{0.40} nanoparticle. The mercury lamp is used as a light source, and the light emitted from the mercury lamp is used by being separated with a monochromator.

In the ZnO_{0.60}S_{0.40} quantum dot ensemble in which the variation occurs in the absorption edge wavelength of the band gap, due to the variations in the mixed crystal composition and the particle size, the particle having the size which is sufficient for absorbing the light absorbs the light such that the light dissolution reaction occurs, the surface of the particle is dissolved in a light dissolving liquid, and thus, the diameter of the particle is gradually decreased. For this reason, as the etching is progressed, the absorption edge wavelength of each particle to be etched is shifted to the short wavelength side. Until the absorption edge wavelength of the quantum dot ensemble becomes shorter than the wavelength of the irradiation light, and the light dissolution reaction is stopped, the quantum dot ensemble is constantly irradiated with the light. The light irradiation is performed, for example, for 20 hours.

Fig. 4B illustrates a schematic diagram of the quantum dot ensemble (ZnOₓS₁₋ₓ nanoparticle ensemble) after being irradiated with the light. The quantum dots having a different mixed crystal composition are mixed in the quantum dot ensemble after being irradiated with the light. In addition, the particle size distribution exists.

Fig. 4C illustrates the relationship between the O composition x and the size of the quantum dot ensemble after being irradiated with the light, and the band gap energy (the light emitting wavelength). Four curved lines in Fig. 4C are the same as those in Fig. 1A. After being irradiated with the light, the quantum dot ensemble has the O composition x is in a range of 0.80 to 0.40, and the size is in a range of 4.0 nm to 6.0 nm on the basis of the target value that the O composition x is 0.60 and the size is 4.0 nm.

However, in the quantum dot ensemble after being irradiated with the light, the light emitting wavelength of the quantum dots are uniformized. For example, a nanoparticle ensemble of 3.06 eV having the band gap energy which is equivalent to the energy of the irradiation light is formed.

As described above, due to the quantum effect through the selective optical etching in Step S102, the variation occurs in the O composition x in a range of 0.40 to 0.80; however, it is possible to manufacture only semiconductor nanoparticles having the constant light emitting wavelength. The nanoparticle (base material) varied in the size, which is larger than the target size is, subjected to the optical etching so as to make particle size small, even though the compositions are different from each other, thereby allowing the quantum dot ensemble having the target wavelength to be obtained.

With the selective optical etching step in Step S102, it is possible to manufacture, for example, the ZnO_{0.60}S_{0.40} mixed crystal nanoparticles (the quantum dots) which have the same band gaps as each other, that is, have the same light emitting wavelength as each other.

In addition, in common with all of the examples including examples described below, the quantum dot ensemble after being irradiated with the light (after performing the selective optical etching) has the band gap energy which is greater than the band gap energy of the bulk mixed crystal due to the quantum effect.

The emission spectrum of an aqueous solution which is obtained by dispersing the quantum dot ensemble (ZnO_{0.60}S_{0.40} nanoparticle ensemble) manufactured by the manufacturing method according to the first embodiment is evaluated by using a spectrophotometer. The emission spectrum having a half-width of 45 nm is obtained by observing the emission spectrum by using the excitation wavelength of 365 nm.

In the first embodiment, the quantum dots are formed of the ternary semiconductor material which has the band gap smaller than that of the binary semiconductor material. In addition, the quantum dots having different mixed crystal compositions are mixed in the quantum dot ensemble (the ZnO_{0.60}S_{0.40} nanoparticle ensemble) which is manufactured through the manufacturing method according to the first embodiment. However, the band gap for each particle is uniformized, and the half width of the emission spectrum as the quantum dot ensemble is less than 50 nm (45 nm). In this way, in the quantum dot ensemble (a nanoparticle phosphor) which is manufactured through the manufacturing method according to the first embodiment, the half width of the emission spectrum is small (the narrow spectrum of light emitting wavelength can be realized).

The light with which the quantum dots (the base material) are irradiated in the optical etching step (Step S102) is the light of the wavelength corresponding to, for example, the band gap (the light emitting wavelength) which is to be obtained at last. In order to uniformly perform the etching in a short time, the light having a small width of the wavelength and high intensity is preferable. Specifically, it is possible to preferably use monochromatic light which is obtained by filtering the light derived from continuous light sources such as laser (continuous waves), and a mercury lamp through a monochromator or a filter. The light is guided into the container in which the nanoparticle is put by the optical fiber such that the quantum dots are irradiated with the light.

In the embodiment, water (ultra pure water) is used as the etching liquid; however, the material as the etching liquid is not particularly limited, as long as a selection ratio of the etching rate is obtained at the time of the light irradiation and non-irradiation. Meanwhile, pH or the temperature of the etching liquid may be adjusted so as to adjust the etching rate.

The quantum effect in which the band gap is changed depending on the particle size is used in the manufacturing method of the quantum dots according to the embodiment. For this reason, the size of the quantum dots which are finally obtained through the selective optical etching step in Step S102 is desired to be within the range of size in which the effect is sensitively obtained. When referring to Fig. 1B, it is found that if the size is decreased, a change amount of the band gap (the wavelength) is increased, that is, the quantum effect can be sensitively obtained. The size of the quantum dots (the average particle size) which are finally obtained is preferably equal to or less than 20 nm, and more preferably equal to or less than 10 nm.

In the synthesizing step of the quantum dot base material in Step S101, the ZnOₓS₁₋ₓ particle which is the quantum dot base material is synthesized in a size larger than the size for the final quantum dots. That is, the ZnOₓS₁₋ₓ particle is synthesized in a size which is larger than 10 nm or 20 nm. The variations in the composition and the size occur between the quantum dots (base material particles). According to the present invention, the variation in the O composition x occurs in a range of 0.40 to 0.80.

Note that, the O composition is set to be 0.60, and the S composition is set to be 0.40 in the first embodiment.

Subsequently, a manufacturing method of a quantum dot ensemble according to the first comparative example will be described. The quantum dot ensemble according to the first comparative example is a type II light emitting nanoparticle ensemble including a core layer formed of a ternary In_{y}Al_{1-y}N (0 < y < 1) crystal which is a group III-V compound semiconductor, and a shell layer formed of a ternary ZnOₓS₁₋ₓ (0 < x < 1) crystal which is a group II-VI compound semiconductor. With the shell layer formed, for example, it is possible to realize the quantum dots which are highly reliable, and chemically and thermally stable. The type II is a structure which has a different spatial position in which electrons and holes are confined by using interband transition between adjacent materials.

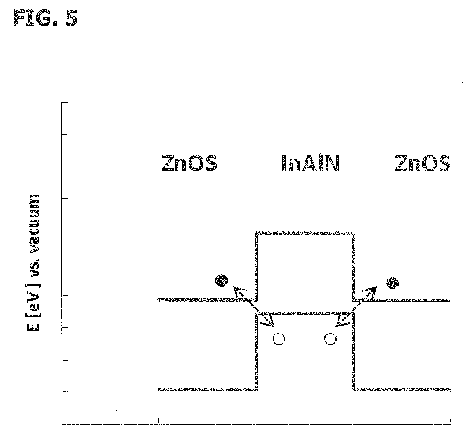

First, with reference to Fig. 5, the band line up of In_{y}Al_{1-y}N (0 < y < 1) and ZnOₓS₁₋ₓ (0 < x < 1) will be described below.

For example, in a case where the core layer is formed of In_{y}Al_{1-y}N (for example, y = 0.67), and the shell layer is formed of ZnOₓS₁₋ₓ (for example, x = 0.75), a type II bonding which is accompanied with the band line up as illustrated in Fig. 5 is ideal. Unlike the type I bonding, the light-emitting transition occurs between a conduction band of ZnOₓS₁₋ₓ and a valance electron band of In_{y}Al_{1-y}N. For this reason, the type II bonding is particularly suitable for emitting the light to, particularly, an area with small light emitting energy such as an infrared area.

However, as for the ternary mixed crystal of ZnOₓS₁₋ₓ (0 < x < 1), it is difficult to control the composition of the mixed crystal. For example, when the target O composition is set that x = 0.75, if approximately ± 30% of variation in the composition occurs, the shell layer having the O composition range x which is in a range of approximately 0.5 to 0.9 can be formed. As a result, an energy difference Δ Ec of the valance electron band between an In_{y}Al_{1-y}N core layer and a ZnOₓS₁₋ₓ shell layer satisfies 0 < Δ Ec < 0.49 eV. In addition, an energy difference Δ Ev of the conduction band is greatly changed such that 0.95 eV < Δ Ev < 1.35 eV is satisfied. In the type II bonding, the light emission is caused in the energy level between the core and the shell, and thus, the variation in the composition ratio causes the change of the energy level, which is a serious problem.

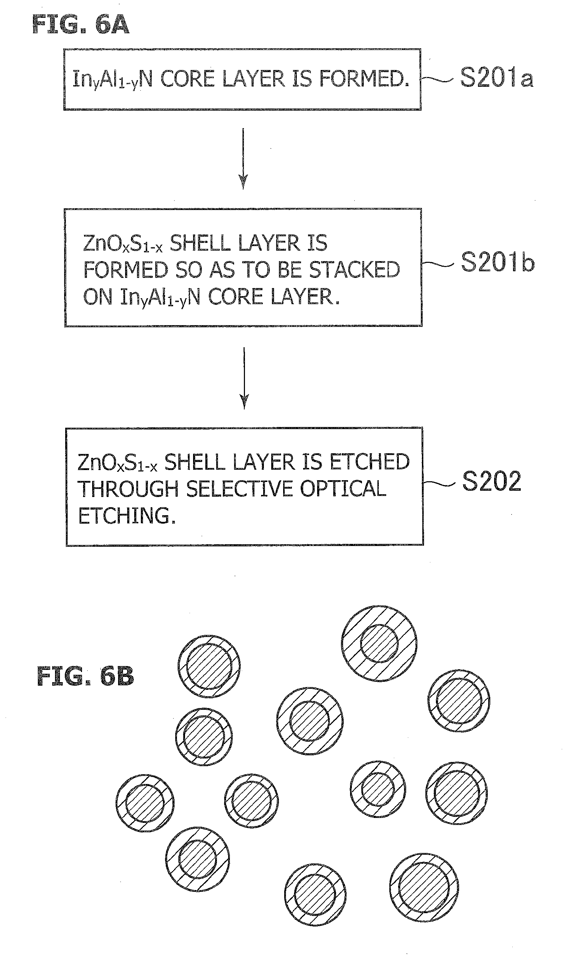

Fig. 6A is a flow chart schematically illustrating the manufacturing method of the quantum dot ensemble according to the first comparative example.

In the first comparative example, first, the In_{y}Al_{1-y}N core layer is formed (Step S201a). Next, the ZnOₓS₁₋ₓ shell layer is formed so as to be stacked on the In_{y}Al_{1-y}N core layer formed in Step S201a (Step S201b). Then, the ZnOₓS₁₋ₓ shell layer is etched through the selective optical etching (Step S202).

Step S201a and Step S201b in the first comparative example are steps corresponding to Step S101 in the first embodiment. In addition, Step S202 in the first comparative example is a step corresponding to Step S102 in the first embodiment.

In Step S201a, the In_{y}Al_{1-y}N core layer is synthesized by using a liquid phase method such as the hot soap method. In Step S201b, the ZnOₓS₁₋ₓ shell layer including the In_{y}Al_{1-y}N core layer is formed in a size larger than the final target size (thickness). For example, the ZnOₓS₁₋ₓ shell layer is formed in a size (thickness) which is larger than 10 nm or 20 nm. In the ZnOₓS₁₋ₓ shell layer formed in Step S201b, for example, the variation in the composition occurs in a range of approximately ± 30% with respect to the target composition.

In Step S202, an etching liquid, which has the core/shell structure formed in Step S201a and Step S201b, such as water is irradiated with the light having the light emitting wavelength of 405 nm (3.06 eV), and the half width of 6 nm, as in the first embodiment. Due to the light irradiation, for example, in the ZnOₓS₁₋ₓ shell layer having the variation in the size (thickness) which is larger than 10 nm, the etching is performed when the shell having a size enough for absorbing the light, and thus the size is decreased (the thickness becomes smaller). On the other hand, when the etching is performed and the size is decreased (the thickness becomes smaller), the energy becomes larger due to the quantum effect such that the light transmits. When the light transmits, the etching is stopped. With the selective optical etching step in Step S202, it is possible to form the ZnOₓS₁₋ₓ shell layer which is formed of ZnOₓS₁₋ₓ, for example, having the same band gap energy.

Fig. 6B illustrates a schematic sectional view of the quantum dot (a core/shell structure) ensemble manufactured through the manufacturing method according to the first comparative example. Quantum dots having, for example, a different diameter and shell thickness are mixed in the quantum dot ensemble manufactured through the manufacturing method according to the first comparative example. However, the band gap energy of the shell layer for each quantum dot is, for example, constant.

The ensemble having a core/shell structure (the ZnOₓS₁₋ₓ shell layer) which is manufactured through the manufacturing method according to the first comparative example has the same effect as that of the quantum dot ensemble manufactured through the manufacturing method according to the first embodiment. Further, according to the manufacturing method in the first comparative example, it is possible to make the band gap energy of the shell layer constant, and thus in the type II light emitting nanoparticle using the ZnOₓS₁₋ₓ shell layer in which various compositions are mixed, it is possible to perform a stable light-emitting transition.

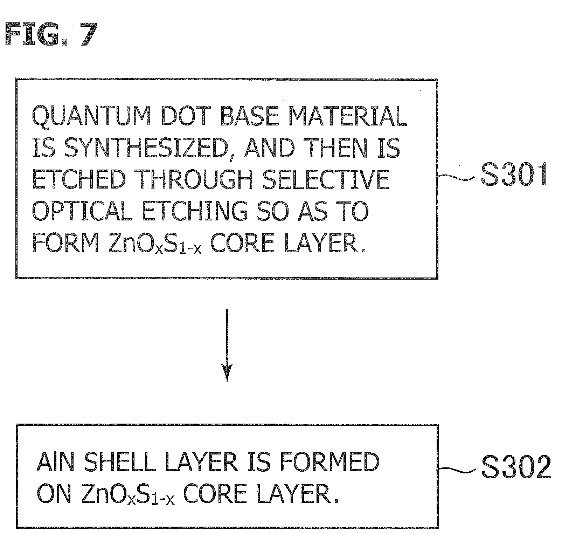

Fig. 7 is a flow chart schematically illustrating the manufacturing method of the quantum dot ensemble according to the second comparative example. The quantum dots manufactured in the second comparative example are a core/shell type quantum dots (light emitting nanoparticles) which have a structure in which a ternary ZnOₓS₁₋ₓ (0 < x < 1) core formed of a group II-VI semiconductor material is coated with an AIN shell.

In the second comparative example, first, the quantum dot base material is formed, and then the synthesized quantum dot base material is etched through the selective optical etching so as to form the ZnOₓS₁₋ₓ core layer (Step S301). Next, an AlN shell layer is formed on the ZnOₓS₁₋ₓ core layer which is formed in Step S301 (Step S302). Step S301 in the second comparative example is a step corresponding to Step S101 and Step S102 in the first embodiment.

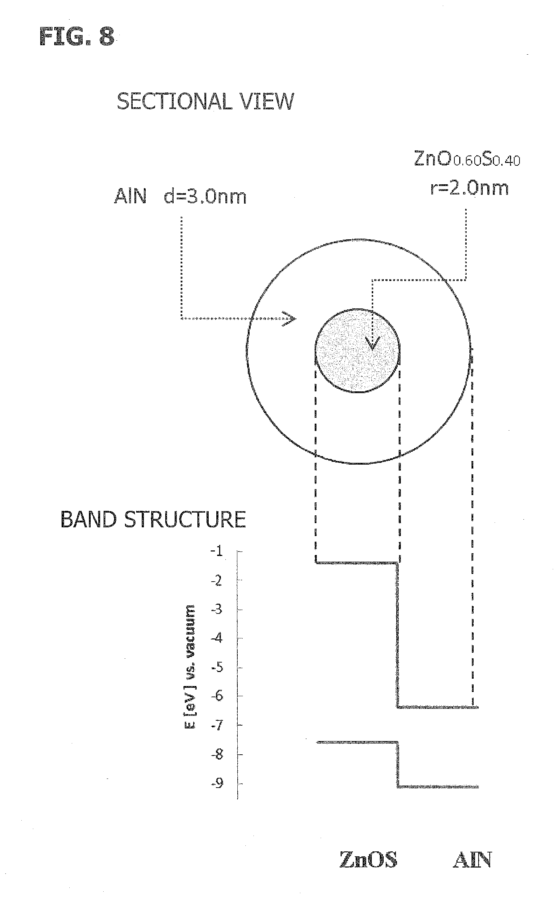

Fig. 8 illustrates a sectional view of the quantum dot which is manufactured through the manufacturing method according to the second comparative example, and a target value of a band structure. Inthe second comparative example, a structure in which a ZnO_{0.60}S_{0.40} core having a diameter of 2.0 nm is coated with the AIN shell having the thickness of 3.0 nm is set to be a target.

In the second comparative example, first, a ZnOₓS₁₋ₓ core layer is formed in the same order as in the first embodiment.

Next, the AIN shell layer is precipitated on the ZnOₓS₁₋ core layer. At this time, for example, a toluene solution which is obtained by dispersing ZnO_{0.60}S_{0.40} nanoparticles (core particles) which are manufactured in the same order as in the first embodiment is used. In addition, the following operations and synthesis in the second comparative example are performed in a glove box by using a vacuum-dried (140°C) glass products and equipment.

6 ml of the toluene solution in which the ZnO_{0.60}S_{0.40} nanoparticles are dispersed, aluminum iodide which is a source of aluminum (171 mg, 0.41 mmol), sodium amide which is a source of nitrogen (500 mg, 12.8 mmol), hexadecanethiol (380 µl, 1.0 mmol) which is a capping agent, zinc stearate (379 mg, 0.6mol), and aqueous solution (20 ml) containing the ZnO_{0.60}S_{0.40} nanoparticles are put into a flask in which diphenyl ether (20 ml) is input as a solvent. A mixture obtained as above is heated until 100°C at an inert gas atmosphere, and kept warm until a separating layer between water and other solvents is eliminated. When the separating layer is eliminated, the reaction solvent is heated up to 225°C, and maintains the temperature to be 225°C for 60 minutes. The reaction container is naturally cooled to 100°C, and then maintained for an hour. With this, it is possible to perform the stabilization of the surface of the nanoparticle. Thereafter, butanol as an anticaking agent is added to the reaction solution which is cooled to room temperature and the reaction solution is left to stand for 10 hours so as to prevent the nanoparticles from being aggregated. The mixture is purified by repeatedly performing centrifugation (4000 rpm for 10 minutes) by alternately using dehydrated methanol in which the solvent (TOPO) is dissolved, and toluene which disperses the nanoparticles. As a result, unnecessary raw materials and the solvent are removed.

By going through such a procedure, it is possible to obtain a nanoparticle in which the shell layer which is formed of AIN is grown on a ZnO_{0.60}S_{0.40} core layer.

The emission spectrum of the toluene solution in which ZnO_{0.60}S_{0.40}/AlN nanoparticles which are manufactured through the manufacturing method according to the second comparative example are dispersed is evaluated with a spectrophotometer. The emission spectrum is observed by using the excitation wavelength of 365 nm, and the emission spectrum having the half width of 45 nm is obtained.

The quantum dot ensemble (ZnO_{0.60}S_{0.40}/AlN nanoparticle ensemble) manufactured through the manufacturing method according to the second comparative example exhibits the same effect as that of the quantum dot ensemble manufactured through the manufacturing method according to the first comparative example.

Note that, the shell layer is formed of the AIN in the second comparative example; however, it is not limited to the AIN. For example, an In_{w}Al_{1-w}N (0 < w < 1) shell may be employed. The configuration of the In_{w}Al_{1-w}N (0 < w < 1) shell will be described in a third comparative example.

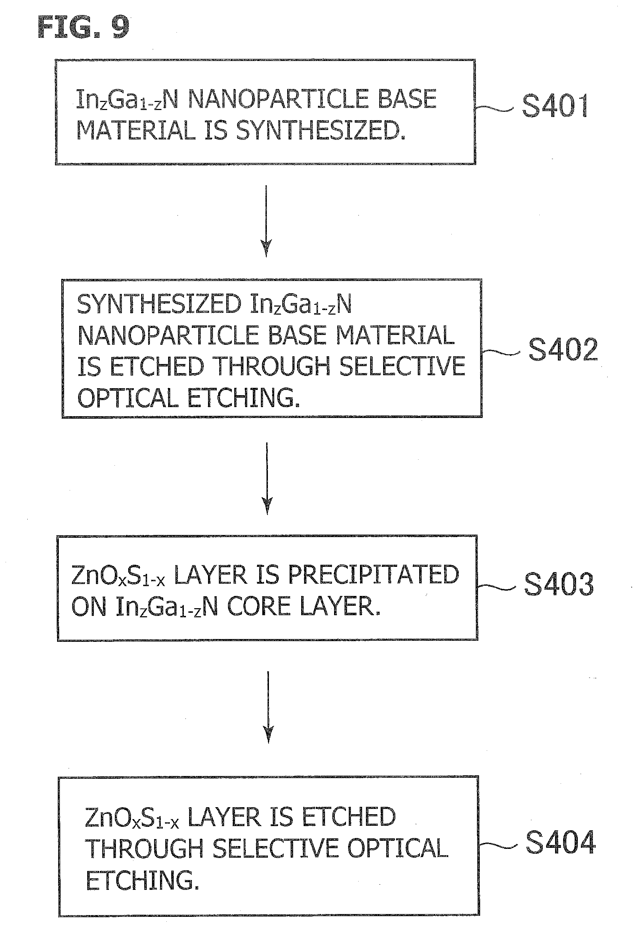

Fig. 9 is a flow chart schematically illustrating the manufacturing method of the quantum dot ensemble according to the second embodiment. The quantum dots which are manufactured in the second embodiment are a type I core/shell type quantum dots (light emitting nanoparticles) having a structure in which a ternary In_{z}Ga_{1-Zn} (0 < z < 1) core formed of the group III-V semiconductor material is coated with a ternary ZnOₓS₁₋ₓ (0 < x < 1) shell. Type I is formed such that a material having a large band gap interposes a material having a small band gap, and the electrons and the holes are confined in the semiconductor material having the small band gap.

In the second embodiment, first, an In_{z}Ga_{1-z}N nanoparticle base material is synthesized (Step S401). Next, the In_{z}Ga_{1-z}N nanoparticle base material which is synthesized in Step S401 is etched through the selective optical etching (Step S402), and an In_{z}Ga_{1-z}N core layer is formed. Further, a ZnOₓS₁₋ₓ layer is precipitated on the In_{z}Ga_{1-z}N core layer which is formed in Step S402 (Step S403). In addition, the ZnOₓS₁₋ₓ layer which is precipitated in Step S403 is etched through the selective optical etching (Step S404), the ZnOₓS₁₋ₓ shell layer is formed on the In_{z}Ga_{1-z}N core layer. Step S401 and Step S403 in the second embodiment are a step corresponding to Step S101 in the first embodiment, and Step S402 and Step S404 are a step corresponding to S102 in the first embodiment.

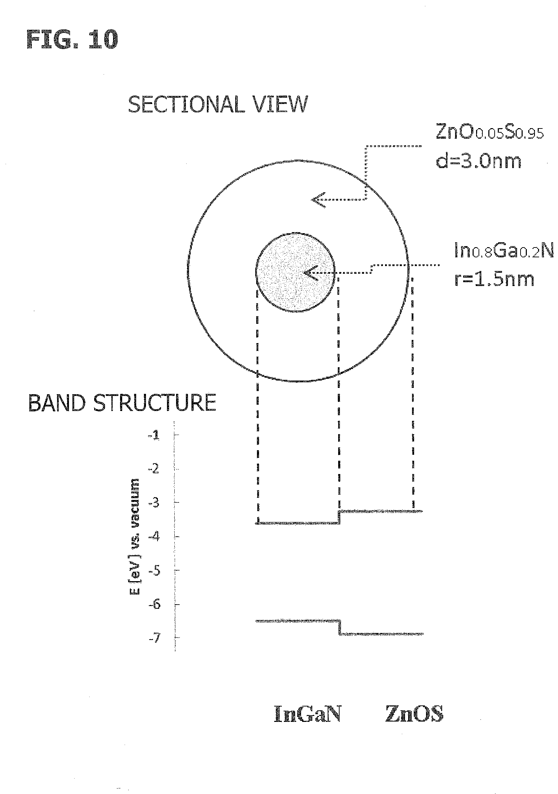

Fig. 10 illustrates a sectional view of the quantum dot manufactured through a manufacturing method according to a further comparative example, whereby a structure in which an In_{0.80}Ga_{0.20}N core having a diameter of 1.5 nm is coated with a ZnO_{0.05}S_{0.95} shell having the thickness of 3.0 nm is set to be a target.

First, a preparing step (Step S401) of the In_{0.80}Ga_{0.20}N nanoparticle base material will be described. In addition, the following operations and synthesis are performed in a glove box by using a vacuum-dried (140°C) glass products and equipment.

Gallium iodide (54 mg, 0.12 mmol) which is a source of gallium, indium iodide (220 mg, 0.48 mmol) which is a source of indium, sodium amide (500 mg, 12.8 mmol) which is a source of nitrogen, hexadecanethiol (380 µl, 1.0 mmol) which is a capping agent, and zinc stearate (379 mg, 0.6 mol) are put into a flask in which diphenyl ether (20 ml) is input as a solvent. The mixed solution is rapidly heated up to 225°C, and maintained at 225°C for 60 minutes. Thereafter, the reaction container is naturally cooled to 100°C, then maintained for an hour. With this, it is possible to perform the stabilization of the surface of the nanoparticle. Thereafter, butanol as an anticaking agent is added to the reaction solution which is cooled to room temperature and the reaction solution is stirred for 10 hours so as to prevent the nanoparticles from being aggregated. The mixture is purified by repeatedly performing centrifugation (4000 rpm for 10 minutes) by alternately using dehydrated methanol in which the solvent (TOPO) is dissolved, and toluene which disperses the nanoparticles. As a result, unnecessary raw materials and the solvent are removed. By going through such a procedure, it is possible to obtain the In_{0.80}Ga_{0.20}N nanoparticle base material.

The In_{0.80}Ga_{0.20}N nanoparticle base material which is synthesized in Step S401 is in a state of being dispersed in the methanol. Here, the methanol is vaporized so as to concentrate the nanoparticles. At this time, if the methanol is completely vaporized, the nanoparticles are aggregated, and therefore, it is preferable that the methanol slightly remains. Ultra pure water which is an optical etching liquid is added to the methanol and a solution of nanoparticle. The mixture is kept at 25°C, and is bubbled with oxygen for 5 minutes.

After being bubbled, the mixture is moved to the sealed container, and then the etching liquid is irradiated with the light having the light emitting wavelength of 405 nm (3.06 eV) and a half width of 6 nm, which is the light having a wavelength which is sufficiently shorter than an absorption edge wavelength of the In_{0.80}Ga_{0.20}N nanoparticle base material (Step S402). The mercury lamp is used as a light source, and the light emitted from the mercury lamp is used by being separated with a monochromator. Due to the variations in the mixed crystal composition and the particle size, the In_{0.80}Ga_{0.20}N nanoparticle base material, in which the variation occurs in the absorption edge wavelength of the band gap, absorbs the light such that the light dissolution reaction occurs, the surface of the particle is dissolved in a light dissolving liquid, and thus the diameter of the particle is gradually decreased. For this reason, as the etching is progressed, the absorption edge wavelength is shifted to the short wavelength side. Until the absorption edge wavelength of the In_{0.80}Ga_{0.20}N nanoparticle base material becomes shorter than the wavelength of the irradiation light, and the light dissolution reaction is stopped, the In_{0.80}Ga_{0.20}N nanoparticle base material is constantly irradiated with the light. The light irradiation is performed, for example, for 20 hours.

A plurality of In_{z}Ga_{1-z}N nanoparticles (core layers) which are formed in Step S402 are, for example, nanoparticles (quantum dots) having the light emitting wavelengths which are the same as each other, even with the mixed crystal compositions and the distribution of the size.

Thereafter, an aqueous solution in which the quantum dots are dispersed is freeze-dried so as to make the quantum dots in a powder state, and thereby the obtained powder is dispersed into octylamine by using ultrasonic dispersing machine.

Subsequently, a step of precipitating the ZnO_{0.05}S_{0.95} shell layer on the In_{0.80}Ga_{0.20}N core layer (Step S403) will be described.

A quartz flask (300 cc) is prepared as a reaction container. A port, through which an inert gas can be replaced with air in the flask, and a dedicated port, into which a reactive precursor can be injected, are attached to the flask in addition to an outlet. TOPO and HDA which are reaction solvents are put into the flask, are heated at 300°C in an inert gas atmosphere, and then dissolved. For example, 8 g of TOPO, 4 g of HDA, and argon (Ar) as the inert gas are used. The above materials are stirred with a stirrer such that heating unevenness is hardly caused.

Next, syringes which are respectively filled with, as the reactive precursor, diethyl zinc (Zn(C₂H₅)₂) sealed by the inert gas (for example, Ar), octylamine (C₈H₁₇NH₂) into which is oxygen is entrapped, bis(trimethylsilyl) sulfide, and a solution containing the In_{0.80}Ga_{0.20}N nanoparticle are respectively prepared. The oxygen is entrapped into octylamine (C₈H₁₇NH₂) by bubbling the oxygen for 2 minutes. Diethyl zinc (Zn(C₂H₅)₂), octylamine (C₈H₁₇NH₂) in which the oxygen is bubbled, and the bis(trimethylsilyl) sulfide are respectively adjusted to be 4.0 mmol, 0.2 mmol, and 3.8 mmol. In addition, 2.0 ml of solution containing the In_{0.80}Ga_{0.20}N nanoparticle is prepared.

When the reaction solvent has reached 225°C that is a reaction temperature, the reactive precursor is added dropwise from each of the syringes. A droplet is added dropwise every 30 seconds. After adding dropwise all droplets of the reactive precursor, the flask is cooled to 100°C, and is incubated for an hour so as to be annealed. With this, it is possible to stabilize the surface of the nanoparticle. Thereafter, butanol as an anticaking agent is added to the reaction solution which is cooled to room temperature and the reaction solution is left to stand for 10 hours so as to prevent the nanoparticles from being aggregated. The mixture is purified by repeatedly performing centrifugation (4000 rpm for 10 minutes) by alternately using dehydrated methanol in which the solvent (TOPO) is dissolved, and toluene which disperses the nanoparticles. As a result, unnecessary raw materials and the solvent are removed. In this way, the In_{0.80}Ga_{0.20}N/ZnO_{0.05}S_{0.95} nanoparticle is formed.

In_{0.80}Ga_{0.00}N/ZnO_{0.05}S_{0.95} nanoparticle is in a state of being dispersed in the methanol. Here, the methanol is vaporized so as to concentrate the nanoparticles. At this time, if the methanol is completely vaporized, the nanoparticles are aggregated, and therefore, it is preferable that the methanol slightly remains. Ultra pure water which is an optical etching liquid is added to the methanol and a solution of nanoparticle. The mixture is kept at 25°C, and is bubbled with oxygen for 5 minutes.

After being bubbled, the mixture is moved to the sealed container, and then the etching liquid is irradiated with the light having the light emitting wavelength of 405 nm (3.06 eV) and a half width of 6 nm, which is the light having a wavelength which is sufficiently shorter than an absorption edge wavelength of ZnO_{0.05}S_{0.95} layer (Step S404). The mercury lamp is used as a light source, and the light emitted from the mercury lamp is used by being separated with a monochromator. Due to the variations in the mixed crystal composition and the particle size, the ZnO_{0.05}S_{0.95} layer, in which the variation occurs in the absorption edge wavelength of the band gap, absorbs the light such that the light dissolution reaction occurs, the surface of the particle is dissolved in a light dissolving liquid, and thus the ZnO_{0.05}S_{0.95} layer becomes gradually thinner. For this reason, as the etching is progressed, the absorption edge wavelength is shifted to the short wavelength side. Until the absorption edge wavelength of the ZnO_{0.05}S_{0.95} layer becomes shorter than the wavelength of the irradiation light, and the light dissolution reaction is stopped, the ZnO_{0.05}S_{0.95} layer is constantly irradiated with the light. The light irradiation is performed, for example, for 20 hours.

The In_{0.80}Ga_{0.20}N/ZnO_{0.05}S_{0.95} nanoparticles are, for example, nanoparticles (quantum dots) having the light emitting wavelengths which are the same as each other, even with the mixed crystal compositions and the distribution of the size.

The emission spectrum of the toluene solution in which the In_{0.80}Ga_{0.20}N/ZnO_{0.05}S_{0.95} nanoparticles are dispersed is evaluated by using the spectrophotometer. The emission spectrum having a half width of 45 nm is obtained by observing the emission spectrum by using the excitation wavelength of 365 nm.

The quantum dot ensemble (an In_{0.80}Ga_{0.20}N/ZnO_{0.05}S_{0.95} nanoparticle ensemble) has the same effect as that of the quantum dot ensemble manufactured through the manufacturing method according to the first comparative example.

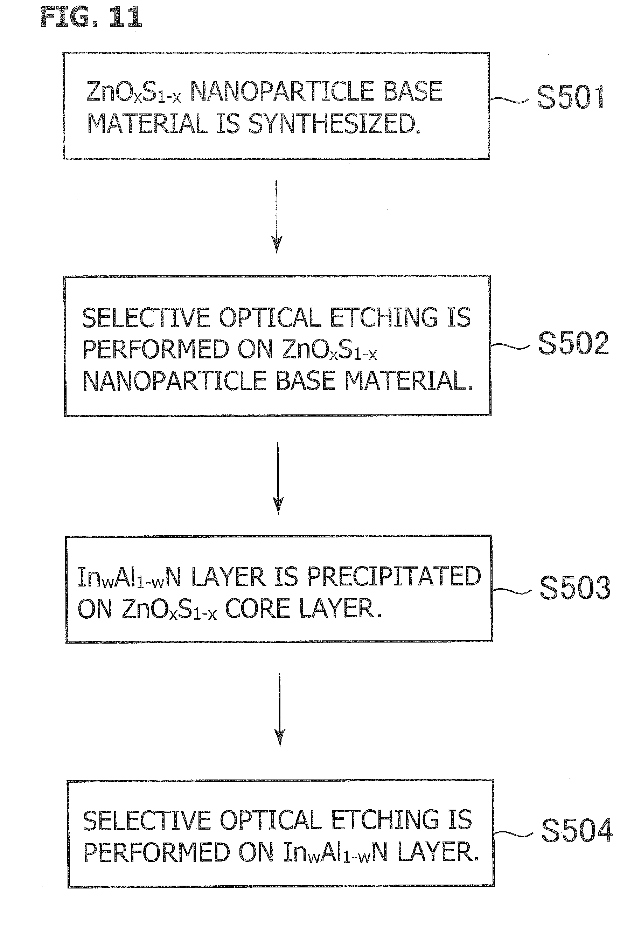

Fig. 11 is a flow chart schematically illustrating the manufacturing method of the quantum dot ensemble according to the third comparative example. The quantum dots manufactured in the third comparative example are a type II core/shell type quantum dots (light emitting nanoparticles) which has a structure in which a ternary ZnOₓS₁₋ₓ (0 < x < 1) core formed of a group II-VI semiconductor material is coated with a ternary In_{w}Al_{1-w}N (0 < w < 1) shell formed of a group III-V semiconductor material.

In the third comparative example, first, a ZnOₓS₁₋ₓ nanoparticle base material is synthesized (Step S501). Next, the ZnOₓS₁₋ₓ nanoparticle base material which is synthesized in Step S501 is etched through the selective optical etching (Step S502), and a ZnOₓS₁₋ₓ core layer is formed. Further, an In_{w}Al_{1-w}N layer is precipitated on the ZnOₓS₁₋ₓ core layer formed in Step S502 (Step S503). In addition, the In_{w}Al_{1-w}N layer which is precipitated in Step S503 is etched through the selective optical etching (Step S504), the In_{w}Al_{1-w}N shell layer is formed on the ZnOₓS₁₋ₓ core layer. Step S501 and Step S503 in the third comparative example are a step corresponding to Step S101 in the first embodiment, and Step S502 and Step S504 are a step corresponding to Step S102 in the first embodiment.

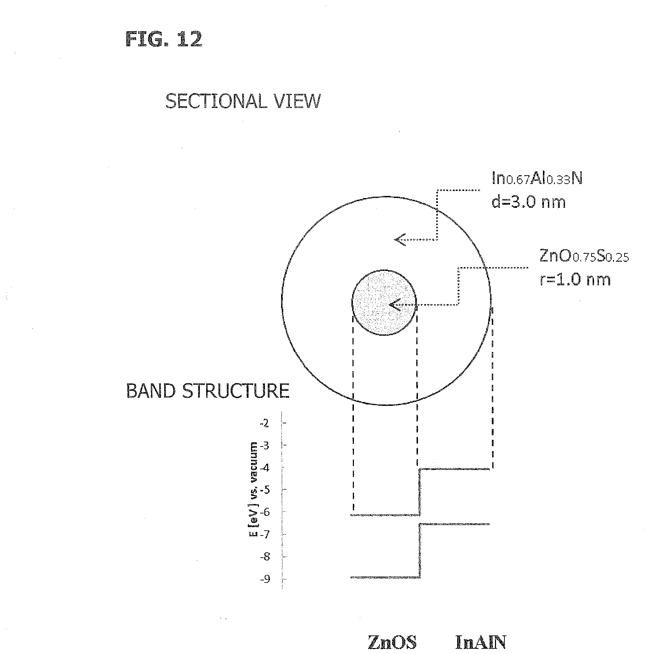

Fig. 12 illustrates a sectional view of the quantum dot manufactured through the manufacturing method according to the third comparative example, and a target value of a band structure. In the third comparative example, a structure in which a ZnO_{0.75}S_{0.25} core having a diameter of 1.0 nm is coated with the In_{0.67}Al_{0.33}N shell having the thickness of 3.0 nm is set to be a target.

First, a synthesizing step (Step S501) of the ZnO_{0.75}S_{0.25} nanoparticle base material will be described.

A quartz flask (300 cc) is prepared as a reaction container. A port, through which an inert gas can be replaced with air in the flask, and a dedicated port, into which a reactive precursor can be injected, are attached to in the flask in addition to an outlet. TOPO and HDA which are reaction solvents are put into the flask, are heated at 300°C in an inert gas atmosphere, and then dissolved. For example, 8 g of TOPO, 4 g of HDA, and argon (Ar) as the inert gas are used. The above materials are stirred with a stirrer such that heating unevenness is hardly caused.

Next, syringes which are respectively filled with, as the reactive precursor, diethyl zinc (Zn(C₂H₅)₂) sealed by the inert gas (for example, Ar), octylamine (C₈H₁₇NH₂) which is bubbled with oxygen, and bis(trimethylsilyl) and sulfide (thiobis) are respectively prepared. Diethyl zinc (Zn(C₂H₅)₂), octylamine (C₈H₁₇NH₂) to which the oxygen is bonded, and bis(trimethylsilyl) sulfide (thiobis) are respectively adjusted to be 4.0 mmol, 3.0 mmol, and 1.0 mmol. By adjusting as described above, a ZnO_{0.75}S_{0.25} mixed crystal nanoparticle is synthesized in the third comparative example. Meanwhile, in order to synthesize a ZnOₓS₁₋ₓ mixed crystal nanoparticle having a different O composition x, the ratio of the materials of the above reaction precursor can be appropriately changed.

When the reaction solvent has reached a reaction temperature, the reactive precursor is immediately put into the flask by using each syringe. A nucleus crystal of ZnOₓS₁₋ₓ is generated by thermal decomposition of the reactive precursor. If the reactive precursor is left to stand as it is, most of the reactive precursors are used to form the nucleus, and different sizes of nuclei are generated over time, and thus the temperature of the flask is rapidly cooled to 200°C immediately after injecting the reactive precursor. Thereafter, a growth of ZnOₓS₁₋ₓ is performed in such a manner that the reaction solvent is heated again up to 240°C, and kept at a certain temperature for 20 minutes.

The flask is naturally cooled to 100°C, and then left to stand for one hour. With this, it is possible to stabilize the surface of the nanoparticle. Thereafter, butanol as an anticaking agent is added to the reaction solution which is cooled to room temperature and the reaction solution is kept for 10 hours so as to prevent the nanoparticles from being aggregated. The mixture is purified by repeatedly performing centrifugation (4000 rpm for 10 minutes) by alternately using dehydrated methanol in which the solvent (TOPO) is dissolved, and toluene which disperses the nanoparticles. As a result, unnecessary raw materials and the solvent are removed.

As described above, the ZnO_{0.75}S_{0.25} nanoparticle base material is synthesized. However, in the ensemble of the nanoparticle base materials which are synthesized in Step S501, variations in the mixed crystal composition and the particle size occur for each particle.

While this variations exist, the process proceeds to an In_{w}Al_{1-w}N shell layer forming step (Step S503), and the quantum effect is changed for each ZnO_{0.75}S_{0.25} nanoparticle, which results in the variation in the light emitting wavelength. In Step S502, the selective optical etching is performed so as to uniformize band gaps of the entire ZnO_{0.75}S_{0.25} nanoparticles.

The ZnO_{0.75}S_{0.25} nanoparticle base material is synthesized in Step S501 in a state of being dispersed in the methanol. Here, the methanol is vaporized so as to concentrate the nanoparticles. At this time, if the methanol is completely vaporized, the nanoparticles are aggregated, and therefore, it is preferable that the methanol slightly remains. Ultra pure water which is an optical etching liquid is added to the methanol and a solution of nanoparticle. The mixture is kept at 25°C, and is bubbled with oxygen for 5 minutes.

After being bubbled, the mixture is moved to the sealed container, and then the etching liquid is irradiated with the light having the light emitting wavelength of 405 nm (3.06 eV) and a half width of 6 nm, which is the light having a wavelength which is sufficiently shorter than an absorption edge wavelength of the ZnO_{0.75}S_{0.25} nanoparticle. The mercury lamp is used as a light source, and the light emitted from the mercury lamp is used by being separated with a monochromator.

Due to the variations in the mixed crystal composition and the particle size, the ZnO_{0.75}S_{0.25} nanoparticle, in which the variation occurs in the absorption edge wavelength of the band gap, absorbs the light such that the light dissolution reaction occurs, the surface of the particle is dissolved in a light dissolving liquid, and thus the diameter of the particle is gradually decreased. For this reason, as the etching is progressed, the absorption edge wavelength is shifted to the short wavelength side. Until the absorption edge wavelength of the ZnO_{0.75}S_{0.25} becomes shorter than the wavelength of the irradiation light, and the light dissolution reaction is stopped, the ZnO_{0.75}S_{0.25} is constantly irradiated with the light. The light irradiation is performed, for example, for 20 hours.

In Step S502, for example, a plurality of ZnO_{0.75}S_{0.25} nanoparticles (ZnO_{0.75}S_{0.25} core layers) which have the light emitting wavelengths which are the same as each other are formed, even with the mixed crystal compositions and the distribution of the size.

Subsequently, a step of precipitating the In_{0.67}Al_{0.33}N layer on the ZnO_{0.75}S_{0.25} core layer (Step S503) will be described.

An organic solvent in which the ZnO_{0.75}S_{0.25} nanoparticles (51.7 mg, 0.6 mmol) formed in Step S502 are dispersed, aluminum iodide (80 mg, 0.20 mmol) which is a source of aluminum, indium iodide (185 mg, 0.40 mmol) which is a source of indium, hexadecanethiol (380 µl, 1.0 mmol) which is a capping agent, and zinc stearate (379 mg, 0.6 mol) are put into a flask in which diphenyl ether (20 ml) is input as a solvent. The mixed solution is rapidly heated at 225°C, and maintained at 225°C for an hour. Thereafter, the reaction container is naturally cooled to 100°C, then maintained for an hour. With this, it is possible to stabilize the surface of the nanoparticle. Thereafter, butanol as an anticaking agent is added to the reaction solution which is cooled to room temperature and the reaction solution is left to stand for 10 hours so as to prevent the nanoparticles from being aggregated. The mixture is purified by repeatedly performing centrifugation (4000 rpm for 10 minutes) by alternately using dehydrated methanol in which the solvent (TOPO) is dissolved, and toluene which disperses the nanoparticles. As a result, unnecessary raw materials and the solvent are removed. By going through such a procedure, it is possible to obtain a nanoparticle in which a shell layer which is formed of an In_{0.67}Al_{0.33}N is grown on a ZnO_{0.75}S_{0.25} core layer.

The ZnO_{0.75}S_{0.25}/In_{0.67}Al_{0.33}N nanoparticle (base material) is synthesized until Step S503, variations in the mixed crystal composition and the film thickness of the In_{0.67}Al_{0.33}N layer occur to some extent due to the nanoparticle. If the variations exist, the band structure of the shell layer is varied, and thereby the light emitting wavelength from the nanoparticle broadly spreads, which is a problem. In this regard, in Step S504, the optical etching is performed on the In_{0.67}Al_{0.33}N layer of the ZnO_{0.75}S_{0.25}/In_{0.67}Al_{0.33}N nanoparticle such that the quantum effect is uniformized on the In_{0.67}Al_{0.33}N layer.

The ZnO_{0.75}S_{0.25}/In_{0.67}Al_{0.33}N nanoparticle (base material) is formed in Step S503 in a state of being dispersed in the methanol. Here, the methanol is vaporized so as to concentrate the nanoparticles. At this time, if the methanol is completely vaporized, the nanoparticles are aggregated, and therefore, it is preferable that the methanol slightly remains. Ultra pure water which is an optical etching liquid is added to the methanol and a solution of nanoparticle. The mixture is kept at 25°C, and is bubbled with oxygen for 5 minutes.

After being bubbled, the mixture is moved to the sealed container, and then the etching liquid is irradiated with the light having the light emitting wavelength of 405 nm (3.06 eV) and a half width of 6 nm, which is the light having a wavelength which is sufficiently shorter than an absorption edge wavelength of the In_{0.67}Al_{0.33}N layer. The mercury lamp is used as a light source, and the light emitted from the mercury lamp is used by being separated with a monochromator.

Due to the variations in the mixed crystal composition and the particle size, the In_{0.67}Al_{0.33}N layer, in which the variation occurs in the absorption edge wavelength of the band gap, absorbs the light such that the light dissolution reaction occurs, the surface of the particle is dissolved in a light dissolving liquid, and thus the In_{0.67}Al_{0.33}N layer becomes gradually thinner. For this reason, as the etching is progressed, the absorption edge wavelength is shifted to the short wavelength side. Until the absorption edge wavelength of the In_{0.67}Al_{0.33}N layer becomes shorter than the wavelength of the irradiation light, and the light dissolution reaction is stopped, the In_{0.67}Al_{0.33}N layer is constantly irradiated with the light. The light irradiation is performed, for example, for 20 hours.

The ZnO_{0.75}S_{0.25}/In_{0.67}Al_{0.33}N nanoparticles which are manufactured through the manufacturing method according to the third comparative example are, for example, nanoparticles having the light emitting wavelengths which are the same as each other, even with the mixed crystal compositions and the distribution of the size.

The quantum dot (the ZnO_{0.75}S_{0.25}/In_{0.67}Al_{0.33}N nanoparticle) ensemble which is manufactured through the manufacturing method according to the third comparative example has the same effect as that of the quantum dot ensemble manufactured through the manufacturing method according to the first comparative example.

Note that, the quantum dot having the core/shell structure in which the surface of the quantum dot is coated with the group II-VI semiconductor material; however, in the quantum dot of the core/shell structure, the core layer and the shell layer do not necessarily satisfy a lattice matching condition. When it comes to obtaining a quantum dot having a good crystallinity, it is preferable to satisfy each lattice matching condition. The matching range is set that a difference of lattice constants is within ± 1.0%. The reason for this is that if the matching range is within the above range, there is substantially no influence on the characteristics, with which the band gap is involved, as the semiconductor, but if the matching range is beyond ± 1%, the characteristics is remarkably deteriorated due to the deterioration of the crystallinity.

In addition, the core/shell structure (a stacking layer structure) is not limited to two layers; for example, it can be formed of three layers or more.

Further, the shape of the quantum dot is not particularly limited, as long as the average particle size is, for example, equal to or less than 20 nm. For example, it is possible to take a shape such as a spherical shape, a polyhedral shape, a flat plate shape.

## Claims

1. A manufacturing method of a quantum dot ensemble, comprising the steps of:
(a) preparing a plurality of quantum dots having a size exceeding 10 nm and made of ZnOₓS₁₋ₓ having a variation in oxygen composition x, a target value of the oxygen composition x being set at 0.60, resulting in a variation of oxygen composition x in a range of 0.40 to 0.80; and
(b) selectively and optically etching the quantum dots prepared in the step (a), etching quantum dots having sufficient size for absorbing light, thereby reducing the size of the quantum dots and widening the band gap so that the band gap energy of the plurality of quantum dots becomes uniformalized.

2. The manufacturing method of a quantum dot ensemble, according to Claim 1,
wherein in the step (b), a half-width of an emission spectrum of the quantum dots which have been etched optically is less than 50 nm.

3. The manufacturing method of a quantum dot ensemble, according to Claim 1 or 2,
wherein in the step (b), an average particle size of the quantum dots which have been etched optically is equal to or less than 20 nm.

## Patentansprüche

1. Verfahren zur Herstellung eines Quantenpunkt-Ensembles, wobei das Verfahren die folgenden Schritte umfasst:
(a) Herstellen einer Vielzahl von Quantenpunkten mit einer Größe von mehr als 10 nm und aus ZnOₓS₁₋ₓ mit einer Variation der Sauerstoffzusammensetzung x, wobei ein Zielwert der Sauerstoffzusammensetzung x auf 0,60 festgelegt wird, was zu einer Variation der Sauerstoffzusammensetzung x in einem Bereich von 0,40 bis 0,80 führt; und
(b) selektives und optisches Ätzen der in Schritt (a) hergestellten Quantenpunkte, Ätzen von Quantenpunkten mit ausreichender Größe für die Absorption von Licht, wodurch die Größe der Quantenpunkte verringert und die Bandlücke erweitert wird, so dass die Bandlückenenergie der Vielzahl von Quantenpunkten gleichförmig wird.

2. Herstellungsverfahren für ein Quantenpunkt-Ensemble nach Anspruch 1,
wobei in dem Schritt (b) eine Halbwertsbreite eines Emissionsspektrums der Quantenpunkte, die optisch geätzt wurden, weniger als 50 nm beträgt.

3. Herstellungsverfahren für ein Quantenpunkt-Ensemble nach Anspruch 1 oder 2,
wobei in dem Schritt (b) eine mittlere Teilchengröße der optisch geätzten Quantenpunkte gleich oder kleiner als 20 nm ist.

## Revendications

1. Méthode de fabrication d'un ensemble de points quantiques, la méthode comprenant les étapes de :
(a) préparer une pluralité de points quantiques ayant une taille supérieure à 10 nm et constitués de ZnOₓS₁₋ₓ ayant une variation de la composition en oxygène x, une valeur cible de la composition en oxygène x étant fixée à 0,60, résultant en une variation de la composition en oxygène x dans un domaine de 0,40 à 0,80 ; et
(b) graver sélectivement et optiquement des points quantiques préparés à l'étape (a), graver des points quantiques ayant une taille suffisante pour absorber la lumière, réduisant ainsi la taille des points quantiques et élargissant la bande interdite de sorte que l'énergie de la bande interdite de la pluralité de points quantiques s'uniformise.

2. Méthode de fabrication d'un ensemble de points quantiques selon la revendication 1,
dans lequel, à l'étape (b), la demi-largeur d'un spectre d'émission des points quantiques qui ont été gravés optiquement est inférieure à 50 nm.

3. Méthode de fabrication d'un ensemble de points quantiques, selon la revendication 1 ou 2,
dans lequel, à l'étape (b), la taille moyenne des particules des points quantiques qui ont été gravés optiquement est égale ou inférieure à 20 nm.
